# EUROPEAN PATENT APPLICATION

(11) **EP 2 254 162 A2**
(43) Date of publication of application: **24.11.2010**
(21) Application number: 10163561.3
(22) Date of filing: 21.05.2010
(51) Int. Cl.: H01L 31/18

(54) **A light-transmission thin film solar module and a process for the manufacturing thereof**

(30) Priority: 22.05.2009 CN 200910143012
(71) Applicant: Wuxi Suntech Power Co., Ltd., New District, Wuxi Jiangsu 214-028 (CN); Suntech Power Co., Ltd., Shanghai Jiangsu 201112 (CN)
(72) Inventor: Guo, Peng, 201112, Shanghai (CN); Ma, Xiaoguang, 201112, Shanghai (CN); Song, Xianzhong, 201112, Shanghai (CN)
(74) Representative: HOFFMANN EITLE

(57) **Abstract**

This invention discloses a light-transmission thin film solar module and a process for the manufacturing thereof. A light-transmission area is formed by using a mask-assisted sandblasting etching process comprising: positioning a mask to cover the back electrode of the thin film solar module; and performing a sandblasting etching process to the mask to form the light-transmission area of the thin film solar module. The light-transmission thin film solar module manufactured by using the process of this invention can include a light-transmission area of any pattern at a lower cost and in a large scale production.

## Description

### Technical field

This invention relates to the thin film solar cell field, particularly to a light-transmission thin film solar module and a process thereof.

### Background of the invention

Photovoltaic (PV) power generation is a relatively mature technique in exploiting of renewable energy source and has great potential for development. However, the relative high manufacturing cost of current PV power generation becomes the main factor for preventing its large-scale commercialization, because silicon material for manufacturing solar cells is expensive and common silicon crystal solar cells consume too much silicon material.

A thin film solar cell is widely regarded as the most prospective PV technique of the next generation for its low manufacturing cost, such as low silicon consumption, simple process, etc. In addition, as thin film solar cells have good appearance and heat insulating effect, more and more urban architectures use PV curtain walls made of thin film solar cells to replace traditional glass walls. At the same time, the power generation function allows thin film solar cells to have huge market potential.

Usually, a thin film solar cell is made by sequentially depositing a first electrode layer, a semiconductor layer (usually, thin film silicon layer) and a second electrode layer on a glass substrate or other transparent substrates. Since a thin film silicon layer usually is not light-transmission, if thin film solar modules are used as the curtain wall on the whole wall, sunlight will not be able to pass through and reach indoors, whereas if a considerable area of the wall is preserved for mounting light-transmission glass windows, when the total area of the wall is given, the area for mounting thin film solar modules, i.e. the effective photo-electric conversion area, is greatly reduced. In order to solve this problem, usually, light-transmission areas of different shapes are provided to the thin film solar modules as required, so that the modules themselves have a transmittance (the ratio of the light-transmission area to the non-light-transmission area) of 10°/a to 30%. In this case, the whole wall can be used. The photo-electric conversion area is reduced to the least extent while normal indoor lighting is guaranteed.

The methods of forming a light-transmission area in the prior arts include a laser etching process, a wet etching process, a dry etching process, and a stripping process, etc. However, laser etching equipments are expensive. As the size of thin film solar cell substrate increases, the cost of laser etching equipments grows higher and so does the manufacturing cost of thin film solar cells. The wet etching, the dry etching and the stripping processes are complex and difficult to control, thus they are not suitable for high-quality mass production.

### Summary of the invention

In view of the above problems of the prior arts, the objective of this invention is to provide a cost effective light-transmission thin film solar module and a process thereof that are suitable for mass production.

In order to achieve the above objective, this invention provides a process for manufacturing a light-transmission thin film solar module, **characterized in that** a light-transmission area is formed by using a mask-assisted sandblasting etching process, the mask-assisted sandblasting etching process comprising: positioning a mask to cover the back electrode of the thin film solar module; and performing a sandblasting etching process (that is, an etching process by sandblasting) to the mask to form the light-transmission area of the thin film solar module.

Preferably, the light-transmission area is linear open grooves which are parallel to each other and have equal intervals therebetween or the light-transmission area is open grooves arrayed in the shape of matrix.

Preferably, after the light-transmission area is formed, separating lines are provided outside of the light-transmission area.

In order to achieve the above objective, this invention also provides a light-transmission thin film solar module having a light-transmission area, being **characterized in that** the thin film solar module is made by using the above process.

By forming a light-transmission area using a mask-assisted sandblasting etching process, the advantageous effects of this invention are simplified process and greatly reduced manufacturing cost of thin film solar modules while guaranteeing the product quality.

### Description of the drawings

Figure 1 is the flowchart of the process for manufacturing a light-transmission thin film solar module of Embodiment 1 of this invention;
Figure 2 is a schematic drawing of figure 1;
Figure 3 is a schematic drawing of the front view of the light-transmission thin film solar module of Embodiment 1;
Figure 4 is a cross-sectional view of figure 3 in the line A-A;
Figure 5 is the flowchart of the process for manufacturing a light-transmission thin film solar module of Embodiment 2 of this invention;
Figure 6 is a schematic drawing of the front view of the light-transmission thin film solar module of Embodiment 2; and
Figure 7 is an enlarged view of a part of figure 6.

### Embodiments

The followings are detailed explanations of the embodiments of this invention with reference to the figures.

### Embodiment 1:

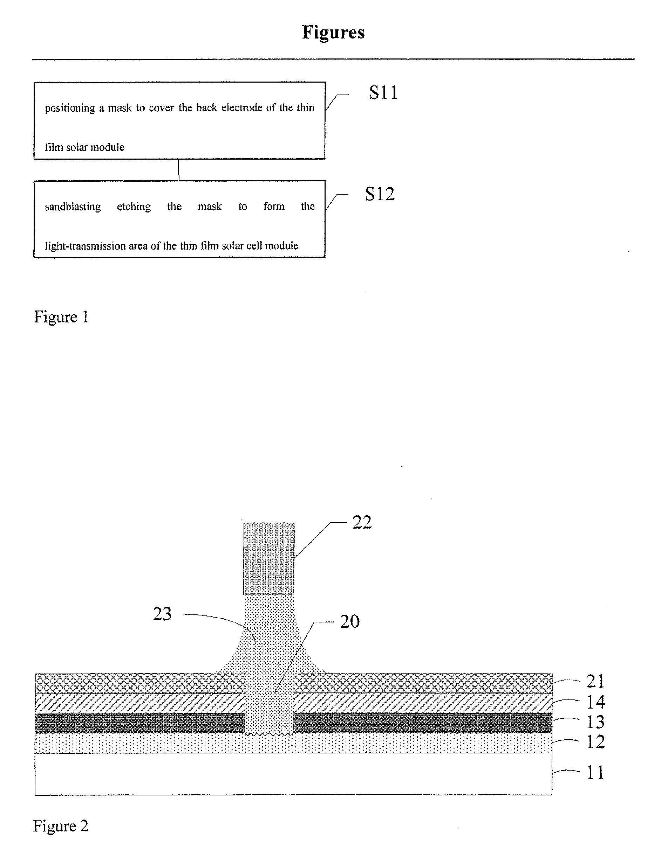

As shown in figure 1, the process for manufacturing a light-transmission thin film solar module of this invention comprises:
S11, positioning a mask to cover the back electrode of the thin film solar module; and
S12, performing a sandblasting etching process to the mask to form the light-transmission area of the thin film solar module.

The procedure of forming the light-transmission area using the mask-assisted sandblasting etching process is shown in the schematic drawing of figure 2. The thin film solar module comprises an insulating light-transmission substrate 11, a transparent electrode layer 12, a semiconductor layer 13, and a back electrode layer 14. A pre-manufactured mask 21 having a pattern is positioned to cover the back electrode layer 14. The sandblasting equipment 22 performs sandblasting to the mask 21. The sandblasting etching depth is controlled by a controlled unit. After the back electrode layer 14 and the semiconductor layer 13 are etched away and a light-transmission area 20 is formed, sandblasting is terminated and the mask 21 is removed. The light-transmission area in this Embodiment may be linear open grooves which are parallel to each other and have equal intervals therebetween or may be open grooves arrayed in the shape of matrix or open grooves having any other patterns so long as the desired pattern is pre-manufactured on the mask 21.

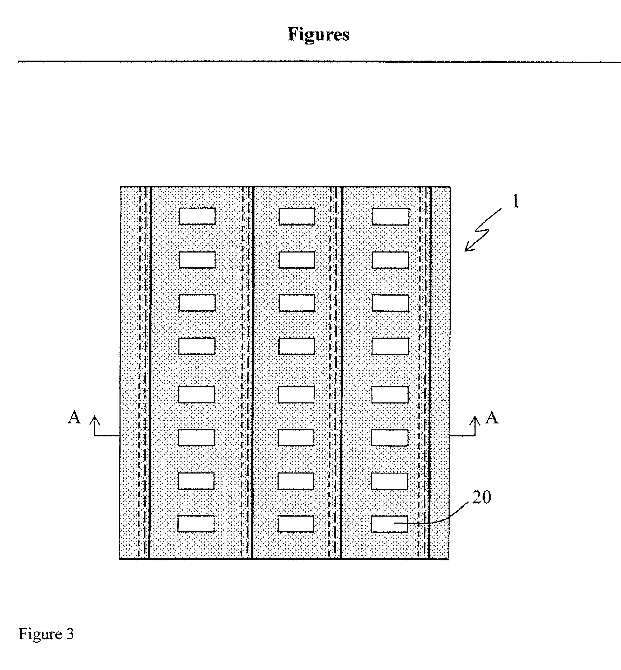

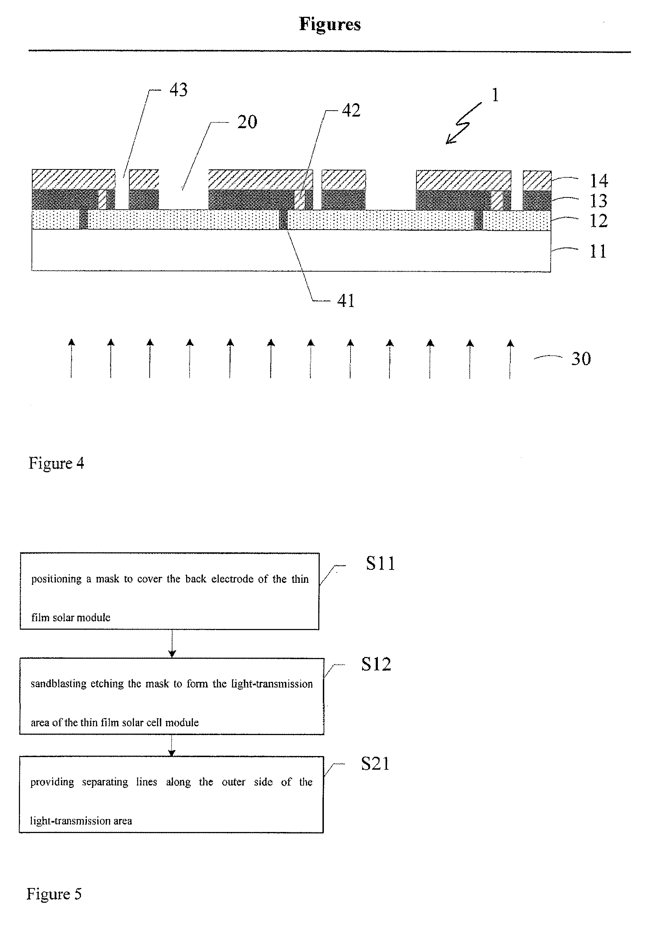

As shown in the schematic drawing of the front view of the light-transmission thin film solar module in figure 3 and the cross-sectional view of the line A-A of figure 3 in figure 4, the light-transmission thin film solar module 1 comprises an insulating light-transmission substrate 11, a transparent electrode layer 12, a semiconductor layer 13, a back electrode layer 14, a first open groove 41, a second open groove 42, a third open groove 43 and a light-transmission area 20. The light-transmission area 20 is formed by using the above sandblasting etching process. The whole light-transmission area 20 comprises a plurality of open grooves arrayed in the shape of matrix, with each of the open grooves in one of a rectangular, circular and diamond shape, such as the rectangular shape shown in figure 3.

In practical use, sunlight 30 can pass the insulating light-transmission substrate 11, the transparent electrode layer 12 and the light-transmission area 20, such that the thin film solar module has good light-transmission.

Since the area of the light-transmission area is usually large, if the laser etching process is used, the cost will be very high, and the wet etching, the dry etching and the stripping processes are complex and difficult to control.

The advantageous effect of this embodiment is that the light-transmission area having a pattern of any shape can be formed by using the simple mask-assisted sandblasting etching process, so that the thin film solar module has good light-transmission and the manufacturing cost is reduced.

### Embodiment 2:

Based on Embodiment 1, in order to improve the quality of the product, after the light-transmission area is formed as shown in the flowchart of the process for manufacturing a light-transmission thin film solar module of this embodiment in figure 5, the process further comprises:
S21, providing separating lines along the outer side of the light-transmission area.

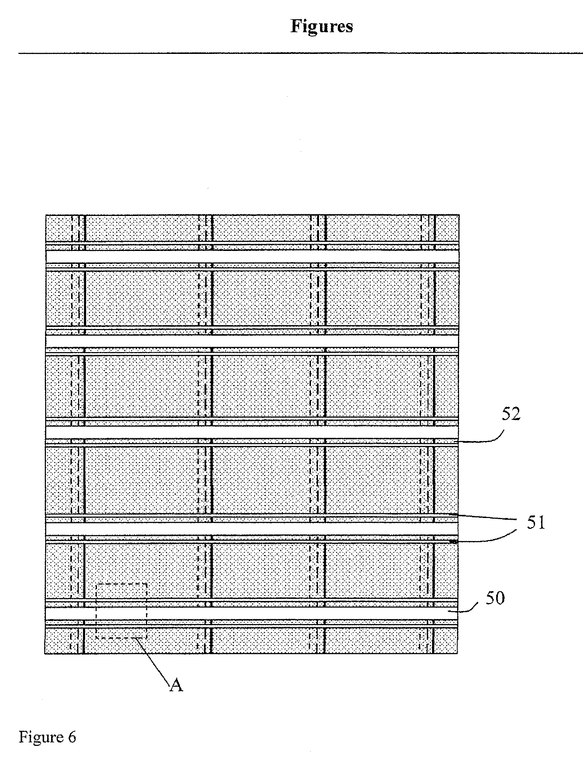

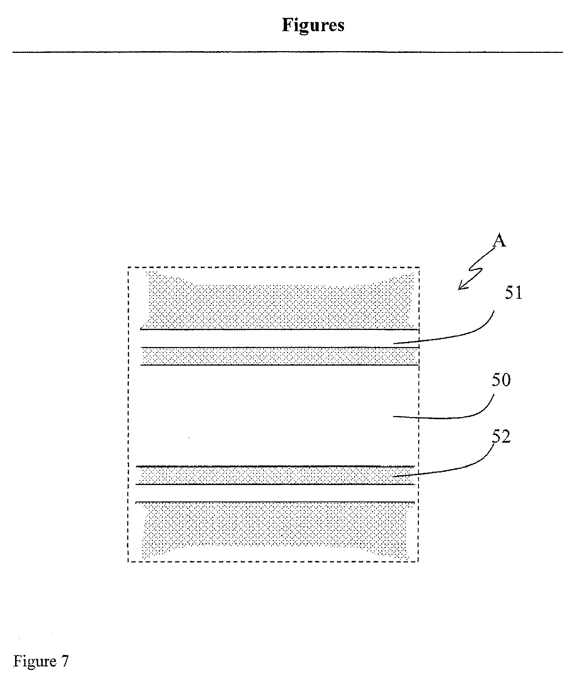

As shown in the schematic drawing of the front view of the light-transmission thin film solar module of figure 6, the light-transmission area 50 in the figure is open grooves which are parallel to each other and have equal intervals therebetween. When forming the light-transmission area 50 having open grooves of such a shape using the sandblasting etching process, the blasted sand 23 may be accumulated at the edge of the light-transmission area 50. As the blasted sand 23 usually contains metal particles and the etched metal electrode generates a great number of metal particles during sandblasting, a short circuit may occur between the back electrode layer 14 and the transparent electrode layer 12 via the accumulated metal particles, thereby affecting the performance of the thin film solar module and causing quality problems. In order to eliminate the possible short circuit, a separating line 51 is respectively provided at both sides of the light-transmission area 50 along the parallel open groove having equal intervals therebetween, such that the residue area 52 where a short circuit may exist and the effective photo-electrical conversion area are separated. The separating line 51 may be formed by using a laser etching process. Specifically, as shown in the enlarged view of a part of figure 6 in figure 7, since the width of the residue area 52 is very small, it almost does not affect the area of the effective photo-electrical conversion area. And since the width of the separating line 51 is small, the use of laser etching process almost does not increase the manufacturing cost.

Of course, if the light-transmission area is formed by open grooves arrayed in the shape of matrix, the separating lines may be provided along the outer side of each open groove; if the light-transmission area is any other pattern, the separating lines may be provided along the outer side of the corresponding pattern.

Since the separating lines eliminate the possible short circuit between the back electrode layer 14 and the transparent electrode layer 12 when forming the light-transmission area using the sandblasting etching process, the advantageous effects of this embodiment are improved product quality and almost no increase in manufacturing cost.

The above embodiments are only illustrative examples of this invention and are not to limit this invention. The protection scope of this invention is defined by the attached claims. A person skilled in the art may make modifications or substitutions within the spirit and protection scope of this invention. Such modifications or substitutions shall also be deemed to be within the protection scope of this invention.

## Claims

1. A process for manufacturing a light-transmission thin film solar module, **characterized in that** a light-transmission area is formed by using a mask-assisted sandblasting etching process, the mask-assisted sandblasting etching process comprising:
positioning a mask to cover the back electrode of the thin film solar module; and
performing a sandblasting etching process to the mask to form the light-transmission area of the thin film solar module.

2. The process for manufacturing a light-transmission thin film solar module according to claim 1, **characterized in that** the light-transmission area is linear open grooves which are parallel to each other and have equal intervals therebetween or the light-transmission area is open grooves arrayed in the shape of matrix.

3. The process for manufacturing a light-transmission thin film solar module according to claim 1 or 2, **characterized by**, after the light-transmission area is formed, further comprising:
providing separating lines along the outer side of the light-transmission area.

4. The process for manufacturing a light-transmission thin film solar module according to claim 3, **characterized in that** the separating lines are formed by using a laser etching process.

5. A light-transmission thin film solar module having a light-transmission area, **characterized in that** the thin film solar module is made by using the process of claim 3 or 4.
